# EUROPÄISCHE PATENTSCHRIFT

(11) **EP 3 942 615 B1**
(45) Veröffentlichungstag und Bekanntmachung des Hinweises auf die Patenterteilung: **07.06.2023**
(21) Anmeldenummer: 20711077.6
(22) Anmeldetag: 05.03.2020
(51) Int. Cl.: H01L 31/0224, H01L 31/048, H01L 31/18, H01L 51/44, H01L 51/00, H01L 51/52

(54) **TRANSPARENTE MEHRSCHICHTANORDNUNG UND HERSTELLUNGSVERFAHREN**
TRANSPARENT MULTI-LAYER ASSEMBLY AND PRODUCTION METHOD
DISPOSITIF MULTICOUCHE TRANSPARENT ET PROCÉDÉ DE FABRICATION

(30) Priorität: 19.03.2019 DE 102019203696
(43) Veröffentlichungstag der Anmeldung: 26.01.2022
(73) Patentinhaber: Albert-Ludwigs-Universität Freiburg, 79098 Freiburg (DE)
(72) Erfinder: EICKENSCHEIDT, Max, 79106 Freiburg (DE); MITTNACHT, Annette, 79114 Freiburg (DE); STIEGLITZ, Thomas, 79110 Freiburg (DE); ALT, Marie T., 79111 Freiburg (DE)
(74) Vertreter: Grünecker Patent- und Rechtsanwälte PartG mbB
(86) Internationale Anmeldenummer: PCT/EP2020/055829
(87) Internationale Veröffentlichungsnummer: WO 2020/187582

(56) Entgegenhaltungen:
- EP-A1- 2 354 107
- LIN H K ET AL: "Improved bending fatigue behavior of flexible PET/ITO film with thin metallic glass interlayer", MATERIALS LETTERS, Bd. 113, 15. Dezember 2013 (2013-12-15), Seiten 182-185, XP028754281, ISSN: 0167-577X, DOI: 10.1016/J.MATLET.2013.09.084 in der Anmeldung erwähnt
- YASUTOSHI JIMBO ET AL: "Ultraflexible Transparent Oxide/Metal/Oxide Stack Electrode with Low Sheet Resistance for Electrophysiological Measurements", ACS APPLIED MATERIALS & INTERFACES, Bd. 9, Nr. 40, 28. September 2017 (2017-09-28), Seiten 34744-34750, XP055702081, US ISSN: 1944-8244, DOI: 10.1021/acsami.7b12802 in der Anmeldung erwähnt
- LIU H ET AL: "Transparent conducting oxides for electrode applications in light emitting and absorbing devices", SUPERLATTICES AND MICROSTRUCTURES, ACADEMIC PRESS, LONDON, GB, Bd. 48, Nr. 5, 1. November 2010 (2010-11-01), Seiten 458-484, XP027417770, ISSN: 0749-6036 [gefunden am 2010-09-06] in der Anmeldung erwähnt

## Beschreibung

Die vorliegende Erfindung bezieht sich auf eine transparente Mehrschichtanordnung, wie sie beispielsweise zur Herstellung von Solarzellen oder organischen Leuchtdioden (OLED) Verwendung findet, und auf ein entsprechendes Herstellungsverfahren. Die vorliegende Erfindung bezieht sich außerdem auf eine Solarzelle und auf eine OLED mit einer solchen transparenten Mehrschichtanordnung.

Transparente Elektroden sind beispielsweise ein wesentliches Element flexibler optoelektronischer Anwendungen, wie zum Beispiel Displays, bildgebende Einheiten und Sensoren. Hochleitfähige Elektroden werden dabei bevorzugt, um den elektrischen Widerstand gering zu halten. Insbesondere für sogenannte Wearables, d. h. am Körper tragbare elektronische Geräte, oder implantierbare Anordnungen werden hohe Anforderungen an die Flexibilität, Zuverlässigkeit und Langzeitstabilität gestellt.

Durchsichtige metallische und halbleitende Dünnschichten (sog. TCOs, engl.: transparent conductive oxides) sind in der Solarindustrie und Bildschirmentwicklung von besonderer Bedeutung. Solche TCOs sind beispielsweise in den Veröffentlichungen N. Al-Dahoudi and M. A. Aegerter, "Comparative study of transparent conductive In2O3: Sn (ITO) coatings made using a sol and a nanoparticle suspension," Thin Solid Films, vol. 502, no. 1-2, pp. 193-197, 2006, und H. Liu, V. Avrutin, N. Izyumskaya, Ü. Özgür, and H. Morkoç, "Transparent conducting oxides for electrode applications in light emitting and absorbing devices," Superlattices and Microstructures, vol. 48, no. 5, pp. 458-484, 2010, beschrieben.

Ein Material, das für neuere Entwicklungen häufig benutzt wird, ist der Halbleiter ITO (Indium-Zinn-Oxid), dessen elektrische Eigenschaften durch Dotierung gezielt eingestellt werden können (siehe z. B. T. Minami, "Present status of transparent conducting oxide thin-film development for Indium-Tin-Oxide (ITO) substitutes," Thin Solid Films, vol. 516, no. 17, pp. 5822-5828, 2008).

ITO hat allerdings problematische mechanische Eigenschaften, insbesondere da es durch sein sprödes Bruchverhalten zu Rissbildung neigt. Um ITO trotzdem in die verschiedenen Produktionsprozesse zu integrieren und dabei seine Integrität zu erhalten, wird ITO meistens auf festen Materialen (z.B. Glas oder Metall) abgeschieden, wie dies in den folgenden Artikeln beschrieben ist: H. K. Lin, S. M. Chiu, T. P. Cho, and J. C. Huang, "Improved bending fatigue behavior of flexible PET/ITO film with thin metallic glass interlayer," Mater. Lett., vol. 113, pp. 182-185, 2013; S. K. Park, J. I. Han, D. G. Moon, and W. K. Kim, "Mechanical Stability of Externally Deformed Indium-Tin-Oxide Films on Polymer Substrates," Jpn. J. Appl. Phys., vol. 42, no. Part 1, No. 2A, pp. 623-629, 2003; K. A. Sierros, N. J. Morris, K. Ramji, and D. R. Cairns, "Stress-corrosion cracking of indium tin oxide coated polyethylene terephthalate for flexible optoelectronic devices," Thin Solid Films, vol. 517, no. 8, pp. 2590-2595, 2009; B. Sim, E.-H. Kim, J. Park, and M. Lee, "Highly enhanced mechanical stability of indium tin oxide film with a thin AI buffer layer deposited on plastic substrate," Surf. Coat. Technol., vol. 204, no. 3, pp. 309-312, 2009; D.-P. Tran, H.-I. Lu, and C.-K. Lin, "Effects of cyclic deformation on conductive characteristics of indium tin oxide thin film on polyethylene terephthalate substrate," Surf. Coat. Technol., vol. 283, pp. 298-310, 2015.

Neue Entwicklungen in der Elektronikindustrie tendieren zu flexiblen Basismaterialien aus Polymeren, um veränderbare und komplexere Strukturen mit dem leitenden Film abbilden können. Hierbei treten bei bekannten Strukturen unter anderem die folgenden Probleme auf.

Bekannte ITO-Schichten müssen in dem Produktionsprozess auf einem festen Trägermaterial abgeschieden und strukturiert werden. Folgeschritte dürfen keine thermischen oder mechanischen Spannungen in den Film einbringen, da solche Spannungen Risse und Defekte in dem spröden Film generieren. Thermisches Behandeln (zwischen 200°C und 800°C) des TCO-Films ist aber z. B. für eine sehr gute elektrische Leitfähigkeit unerlässlich (siehe N. Al-Dahoudi and M. A. Aegerter, "Comparative study of transparent conductive In2O3: Sn (ITO) coatings made using a sol and a nanoparticle suspension," Thin Solid Films, vol. 502, no. 1-2, pp. 193-197, 2006).

Eine durchsichtige und flexible Beschichtung und/oder Verkapselung der ITO-Schichten ist somit nur begrenzt möglich und es ist damit auch keine Langlebigkeit garantiert. Gerade in Anwendungsbereichen mit mechanischer Wechselbelastung oder hoher Feuchtigkeit sind aktuelle Ansätze mangelhaft, da nur Schutzschichten möglich sind, die bei Raumtemperatur abgeschieden werden und ausheilen (z. B. Parylen wie in Y. Jimbo et al., "Ultraflexible Transparent Oxide/Metal/Oxide Stack Electrode with Low Sheet Resistance for Electrophysiological Measurements," (eng), ACS applied materials & interfaces, vol. 9, no. 40, pp. 34744-34750, 2017, beschrieben, Silikon oder dergleichen). Diese Schichten stellen dann sehr spezielle Anforderungen an die Reinigungs- und nachgelagerten Entwicklungs-Prozesse.

Zusammenfassend haben momentan verfügbare Mehrschichtanordnungen mit durchsichtigen leitenden oder halbleitenden Dünnschichten den Nachteil, dass keine nachfolgende Beschichtung oder Prozessierung der Schichten vorgenommen werden kann, welche ein Ausheilen bei erhöhten Temperaturen benötigt. Daher ist das TCO immer einer der letzten Prozessschritte oder muss mit Polymeren beschichtet werden, die bei niedrigen Temperaturen nahe der Raumtemperatur abgeschieden werden. Parylen ist gegenwärtig das einzige flexible Polymermaterial, das in einem CVD-Verfahren (chemical vapor deposition) bei Raumtemperatur abgeschieden werden kann, andere CVD-Abscheidungen ergeben keine flexiblen Schichten.

TCO- und ITO-Schichten müssen direkt auf Glas oder einen anderen festen Träger abgeschieden werden, was keine mechanische Flexibilität zulässt.

Um eine ausreichende Haftung zwischen TCO und einem flexiblen Trägerpolymer herzustellen, ist weiterhin bekannt, eine dünne Metallschicht, z. B. Aluminium, Silber, Titan oder Platin, als Haftvermittler einzufügen. Diese Lösung hat allerdings den Nachteil, dass zum einen die elektrischen Eigenschaften stark beeinflusst werden. Weiterhin ist der gesamte Mehrschichtaufbau nicht mehr ausreichend optisch transparent, wenn unter dem TCO eine Metallschicht angeordnet ist.

Es besteht daher ein Bedarf an optisch transparenten Mehrschichtanordnungen, welche die Nachteile der bekannten Lösungen überwinden und dabei sicher und zuverlässig sind, aber dennoch kostengünstig herstellbar sind.

Diese Aufgabe wird durch den Gegenstand der unabhängigen Patentansprüche gelöst. Vorteilhafte Ausführungsformen der vorliegenden Erfindung sind Gegenstand der abhängigen Patentansprüche.

Dabei basiert die vorliegende Erfindung auf der Idee, eine dünne Schicht Siliziumkarbid als Haftvermittler zwischen einem flexiblen durchsichtigen Trägerpolymer und einer elektrisch leitfähigen transparenten Schicht zu verwenden. Die Erfinder der vorliegenden Erfindung konnten zeigen, dass ein solcher SiC-Haftvermittler nur sehr geringen Einfluss auf die elektrischen und halbleitenden Eigenschaften eines TCO-Films hat, dabei aber sowohl optimale Bindungseigenschaften zu der Kohlenstoffchemie des Polymers einerseits und zu der Oxidstruktur des TCO-Films andererseits hat. Das Siliziumkarbid hat mithin eine hervorragende Haftung zu Polymeren basierend auf dem Kohlenstoffanteil und bildet andererseits eine sehr gute Haftung zu dem TCO-Halbleiter aufgrund des Siliziumanteils aus.

Insbesondere umfasst eine transparente Mehrschichtanordnung gemäß der vorliegenden Erfindung eine transparente Trägerstruktur, die ein Polymermaterial aufweist, und eine elektrisch leitfähige transparente Schicht, die ein elektrisch leitfähiges Oxid aufweist, wobei als Haftvermittler zwischen der Trägerstruktur und der elektrisch leitfähigen transparenten Schicht eine Siliziumkarbidschicht angeordnet ist.

Gemäß einer vorteilhaften Ausführungsform der transparenten Mehrschichtanordnung weist das Polymermaterial der Trägerstruktur Polyimid, PI, Polyethylenterephthalat, PET, Polyethylen, PE, Polycabonat, PC, Polyvinylchlorid, PVC, Polyamid, PA, Polytetrafluorethylen, PTFE, Polymethylmetacrylat, PMMA, Polyetheretherketon, PEEK, Polysulfon, PSU, Poly(p-xylylene), Polydimethylsiloxan, PDMS, und/oder Polypropylen, PP, auf. Besonders inert und chemisch stabil ist dabei Polyimid.

Gemäß der vorliegenden Erfindung kann das elektrisch leitfähige Oxid beispielsweise Indiumzinnoxid, ITO, Fluor-Zinn-Oxid, FTO, Aluminium-Zink-Oxid, AZO, und/oder Antimon-Zinn-Oxid, ATO, umfassen.

Damit die transparente Mehrschichtanordnung für sichtbares Licht ausreichend durchsichtig ist, hat die Siliziumkarbidschicht gemäß einer vorteilhaften Weiterbildung der vorliegenden Erfindung eine Dicke zwischen 10 nm und 100 nm, vorzugsweise etwa 50 nm.

Gemäß einer vorteilhaften Weiterbildung der vorliegenden Erfindung ist die elektrisch leitfähige transparente Schicht strukturiert, um mindestens eine Elektrode auszubilden. Dabei kann die mindestens eine Elektrode sowohl eine Einzelelektrode wie auch ein Array aus einer Vielzahl von Elektroden umfassen. In vorteilhafter Weise haften auch fein strukturierte Elektroden zuverlässig an der Trägerstruktur.

Um die elektrisch leitfähige transparente Schicht elektrisch zu isolieren und/oder gegenüber chemischen und mechanischen Beanspruchungen zu schützen, kann in vorteilhafter Weise weiterhin eine transparente Deckschicht, die ein Polymermaterial aufweist und die elektrisch leitfähige transparente Schicht wenigstens teilweise abdeckt, vorgesehen sein.

Dabei kann optional zwischen der Deckschicht und der elektrisch leitfähigen transparenten Schicht als Haftvermittler eine zweite Siliziumkarbidschicht angeordnet sein, um die Haftung der Deckschicht auf der elektrisch leitfähigen transparenten Schicht zu verbessern.

Die vorliegende Erfindung bezieht sich weiterhin auf ein Verfahren zum Herstellen einer transparenten elektrisch leitfähigen Struktur. Das Verfahren umfasst die folgenden Schritte:
Bereitstellen einer transparenten Trägerstruktur, die ein Polymermaterial aufweist,
Aufbringen einer Siliziumkarbidschicht auf die Trägerstruktur,
Aufbringen einer elektrisch leitfähigen transparenten Schicht, die ein elektrisch leitfähiges Oxid aufweist, auf die Siliziumkarbidschicht, so dass die Siliziumkarbidschicht einen Haftvermittler zwischen der Trägerstruktur und der elektrisch leitfähigen transparenten Schicht ausbildet.

Wie bereits erwähnt, kann auf diese Weise kostengünstig und einfach eine transparente Mehrschichtanordnung hergestellt werden, deren einzelne Lagen miteinander zuverlässig und fest verbunden sind, wobei die Mehrschichtanordnung darüber hinaus eine hohe mechanische Flexibilität aufweist.

Gemäß einer vorteilhaften Ausführungsform des erfindungsgemäßen Verfahrens wird die elektrisch leitfähige transparente Schicht mittels eines Fotolithografieprozesses strukturiert. Fotolithografische Prozesse stellen etablierte, serienfertigungstaugliche Verfahren mit hoher Präzision und Reproduzierbarkeit dar.

In vorteilhafter Weise wird die Siliziumkarbidschicht in einem sogenannten PECVD-Verfahren (Plasma enhanced chemical vapor deposition) auf der Trägerstruktur abgeschieden. PECVD ist ein Prozess, bei dem dünne Filme verschiedener Materialien auf Substraten mit geringerer Temperatur abgeschieden werden können als bei Standard CVD (Chemical vapor deposition)- Verfahren. Bei PECVD Verfahren wird die Abscheidung dadurch bewirkt, dass reaktive Gase zwischen parallelen Elektroden zugeführt werden, einer geerdeten Elektrode und einer RF-Elektrode. Die kapazitive Kopplung zwischen den Elektroden regt die reaktiven Gase zu einem Plasma an, welches wiederum zu der gewünschten chemischen Reaktion führt. Dadurch wird das Reaktionsprodukt auf dem Substrat abgeschieden. Das Substrat, das auf der geerdeten Elektrode angeordnet ist, wird typischerweise auf Temperaturen zwischen 250 °C bis 350 °C erhitzt. Im Vergleich dazu verlangen übliche CVD Verfahren normalerweise 600 °C bis 800 °C. Die Erfinder der vorliegenden Erfinder konnten sogar Temperaturen zwischen 100 °C und 120 °C bei der Abscheidung des SiC erreichen, sodass der Fotolack nicht beschädigt wird und mithin ein Lift-off Verfahren und Fotostrukturierungen ermöglicht werden.

Gemäß einer vorteilhaften Weiterbildung des erfindungsgemäßen Verfahrens wird die elektrisch leitfähige transparente Schicht mittels reaktiver Kathodenzerstäubung auf der Siliziumkarbidschicht abgeschieden. Dieses Verfahren, das auch unter der Bezeichnung "Reaktives Sputtern" bekannt ist, bezeichnet ein Abscheideverfahren, bei dem Atome aus einem Festkörper (Target) durch Beschuss mit energiereichen Ionen (vorwiegend Edelgasionen) herausgelöst werden und in die Gasphase übergehen, wobei in einem inerten Arbeitsgas (z. B. Argon) ein oder mehrere reaktive Gase (z. B. Sauerstoff oder Stickstoff) zugesetzt werden. Die Gase reagieren am Target, in der Vakuumkammer oder am Substrat mit den zerstäubten Schichtatomen und bilden neue Materialien. Die entstandenen Reaktionsprodukte scheiden sich anschließend an der Substratoberfläche ab.

Um die elektrisch leitfähige transparente Schicht zu schützen, kann in vorteilhafter Weise weiterhin eine transparente Deckschicht, die ein Polymermaterial aufweist und die elektrisch leitfähige transparente Schicht wenigstens teilweise abdeckt, aufgebracht werden.

Dabei kann zwischen der Deckschicht und der elektrisch leitfähigen transparenten Schicht als Haftvermittler eine zweite Siliziumkarbidschicht abgeschieden werden, um die Haftung der Deckschicht auf der elektrisch leitfähigen transparenten Schicht zu verbessern. Vorzugsweise wird auf diese Siliziumkarbidschicht eine zusätzliche Schicht aus diamantähnlichem Kohlenstoff (engl. Diamond-Like-Carbon, DLC), die nachfolgend als DLC-Schicht bezeichnet wird, aufgebracht, um die Verbindung zu der aufgeschleuderten flüssigen Vorstufe des Polymermaterials weiter zu verbessern, wenn z. B. PI als Polymermaterial für die Deckschicht verwendet wird.

Gemäß einer vorteilhaften Weiterbildung des erfindungsgemäßen Verfahrens können in einem Ätzschritt Kontaktöffnungen in die Deckschicht eingebracht werden, durch die hindurch die elektrisch leitfähige transparente Schicht kontaktierbar ist.

Die vorliegende Erfindung bezieht sich weiterhin auf eine photovoltaische Zelle, nachfolgend auch als Solarzelle bezeichnet, mit einer Absorberschicht und einer transparenten Mehrschichtanordnung gemäß der vorliegenden Erfindung, wobei die elektrisch leitfähige transparente Schicht elektrisch und optisch mit der Absorberschicht verbunden ist.

Wie in dem Übersichtsartikel H. Liu, V. Avrutin, N. Izyumskaya, Ü. Özgür, and H. Morkoç, "Transparent conducting oxides for electrode applications in light emitting and absorbing devices," Superlattices and Microstructures, vol. 48, no. 5, pp. 458-484, 2010, im Detail beschrieben, nutzen Solarzellen den photovoltaischen Effekt, um einfallendes Licht unmittelbar in elektrischen Strom umzuwandeln. Elektron-Loch-Paare werden durch Lichtquanten erzeugt und an einer Grenzfläche von zwei Materialien mit unterschiedlicher Leitungspolarität aufgetrennt. Im Zusammenhang mit leitfähigen Oxiden sind diverse Solarzellentypen interessant. Grundsätzlich können u. a. Dickschicht- und Dünnschicht-Siliziumsolarzellen, Dünnfilmzellen mit einzelnen oder mehreren Sperrschichten, farbstoffsensibilisierte Solarzellen, organische/Polymerzellen und hocheffiziente Solarzellen mit mehreren Sperrschichten basierend auf III-V-Halbleitern unterschieden werden. TCO werden als transparente Elektroden in vielen Typen von Dünnfilmsolarzellen, wie beispielsweise Siliziumdünnfilmsolarzellen, CdTe-Dünnfilmsolarzellen und Kupfer-Indium-Gallium-Diselenid (CIGS)-Dünnfilmsolarzellen eingesetzt. Dabei muss die Ladungsträgerkonzentration in dem TCO gering wie möglich sein, um unerwünschte freie Ladungsträgerabsorption im Infrarotbereich zu verhindern, während die Ladungsträgerbeweglichkeit so hoch wie möglich sein sollte, um eine ausreichend hohe Leitfähigkeit zu erzeugen.

Der Vorteil von Dünnfilmsiliziumzellen besteht unter anderem darin, dass sie kostengünstiger sind. Verschiedene unterschiedliche Photovoltaiktechnologien basieren auf Siliziumdünnfilmen, beispielsweise auf hydrogenisiertem amorphem Silizium (a-Si:H) mit einem quasi-direkten Bandabstand von 1,8 eV, hydrogenisiertem mikrokristallinen Silizium (µc-Si:H) mit einem indirekten Bandabstand von 1,1 eV, einer Kombination aus diesen beiden Formen (mikromorphes Silizium) sowie polykristallinem Silizium auf Glas (PSG).

Die drei erstgenannten Technologien benutzen TCOs als Front- und/oder Rückseitenelektroden. Erfindungsgemäß wird Siliziumkarbid als Haftvermittler zwischen der TCO-Schicht und dem jeweiligen Trägermaterial eingesetzt. Beispielsweise kann eine solche Zelle nach dem "Super-strate"-Prinzip aufgebaut sein, bei dem das Licht durch das Trägermaterial hindurch in die aktive innere Zone eindringt. Für eine solche Solarzelle beginnt der Fertigungsprozess an der im Betrieb dem Licht zugewandten Vorderseite der Zelle und schreitet zur Rückseite hin fort. Zunächst wird eine TCO-Frontkontaktschicht auf einer transparenten Substratschicht abgeschieden, gefolgt von der Abscheidung von amorphem und/oder mikrokristallinem Silizium und einer TCO- oder metallischen Rückseitenkontaktschicht. Somit muss die TCO-Frontkontaktschicht ausreichend robust sein, um alle nachfolgenden Schichtabscheidungen und Behandlungsschritte unbeschadet zu überstehen. Bei bekannten Anordnungen ist die Substratschicht meist aus Glas. Gemäß der vorliegenden Erfindung wird aber eine Polymerschicht verwendet, so dass die Solarzelle auch flexibel ist.

Die vorliegende Erfindung bezieht sich schließlich auch auf eine organische Leuchtdiode, OLED, mit einer Kathode, einer Emitterschicht und einer Anode, wobei die OLED eine transparente Mehrschichtanordnung gemäß der vorliegenden Erfindung aufweist, und wobei die elektrisch leitfähige transparente Schicht die Anode der OLED bildet.

Es werden nachfolgend die folgenden Begriffe und Definitionen verwendet.

Der Begriff "flexibel" bedeutet im Zusammenhang mit der vorliegenden Erfindung, dass eine Schicht oder ein Substrat biegsam und insbesondere in bestimmten Grenzen deformierbar ist, ohne zu brechen.

Unter der Bezeichnung "elektrisch leitfähig" wird nachfolgend verstanden, dass ein Material in der Lage ist, elektrischen Strom zu leiten und sich zur Ausbildung von Elektroden eignet. Neben der Leitfähigkeit, die beispielsweise Metalle an den Tag legen, soll damit im Sinne der vorliegenden Erfindung auch die Leitfähigkeit eines halbleitenden Materials umfasst sein.

Die Begriffe "transparent" und "durchsichtig" sollen im Sinne der vorliegenden Erfindung die hohe Durchlässigkeit für spezifische Lichtwellenlängen, insbesondere im sichtbaren Bereich, bezeichnen. Allerdings ist für einen Fachmann klar, dass die Prinzipien der vorliegenden Erfindung auch im Zusammenhang mit einer Strahlungsdurchlässigkeit im infraroten Bereich anwendbar sind.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einige Merkmale oder Merkmalskombinationen aus den gezeigten und beschriebenen unterschiedlichen Ausführungsformen für sich eigenständige, erfinderische oder erfindungsgemäße Lösungen darstellen. Es zeigen:
- **Fig. 1-6**: eine schematische Darstellung eines Herstellungsprozesses einer transparenten Mehrschichtanordnung gemäß einer ersten Ausführungsform der vorliegenden Erfindung;
- **Fig. 7-13**: eine schematische Darstellung eines Herstellungsprozesses einer transparenten Mehrschichtanordnung gemäß einer zweiten Ausführungsform der vorliegenden Erfindung;
- **Fig. 14**: eine schematische Darstellung der wellenlängenabhängigen Transmittanz diverser Schichten;
- **Fig. 15**: eine schematische Darstellung einer ersten Ausführungsform einer Solarzelle gemäß der vorliegenden Erfindung;
- **Fig. 16**: eine schematische Darstellung einer zweiten Ausführungsform einer Solarzelle gemäß der vorliegenden Erfindung;
- **Fig. 17**: eine schematische Darstellung einer vorteilhaften Ausführungsform einer OLED gemäß der vorliegenden Erfindung.

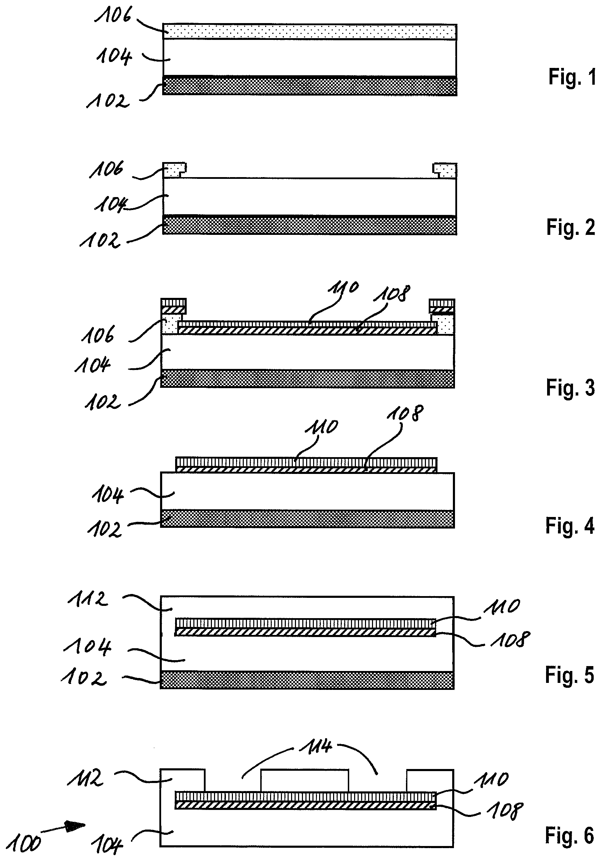

Die vorliegende Erfindung wird der erfindungsgemäße transparente Mehrschichtaufbau gemäß einer ersten Ausführungsform und seine Herstellung nachfolgend mit Bezug auf die Figuren, und dabei insbesondere zunächst mit Bezug auf die Figuren 1 bis 6, näher erläutert. Es wird angemerkt, dass in sämtlichen Figuren die Größenverhältnisse und insbesondere die Schichtdickenverhältnisse nicht maßstabsgetreu wiedergegeben sind.

Fig. 1 zeigt als Ausgangsmaterial schematisch einen Siliziumwafer 102, der mit einer transparenten Trägerschicht, beispielsweise einer Polyimidschicht, 104 und einem Fotolack 106 beschichtet ist. Der Siliziumwafer 102 dient nur während der mikrosystemtechnischen Herstellung der erfindungsgemäßen Mehrschichtanordnung 100 als Substrat und wird später entfernt. In einem photolithographischen Belichtungs- und Strukturierungsschritt wird, wie dies allgemein bekannt ist, der Fotolack so strukturiert, dass das Polyimid (PI) 104 in den Bereichen freigelegt ist, in denen die spätere TCO-Struktur (beispielsweise ITO) ausgebildet werden soll (Fig. 2).

Im nächsten Schritt wird gemäß der vorliegenden Erfindung zunächst eine durchgehende Schicht von Siliziumkarbid 108 aufgebracht.

Dabei erfolgt die Aufbringung der Siliziumkarbidschicht 108 vorzugsweise mittels einer PECVD-Abscheidung. Die Siliziumkarbidschicht 108 kann beispielsweise eine Dicke von 50 nm haben. In diesem Dickenbereich, aber auch noch deutlich darüber, ist Siliziumkarbid für die meisten interessierenden Wellenlängen durchlässig. Wie bereits erwähnt, bezeichnet PECVD (Plasma enhanced chemical vapor deposition) einen Prozess, bei dem dünne Filme verschiedener Materialien auf Substraten mit geringerer Temperatur abgeschieden werden können als bei Standard CVD (Chemical vapor deposition)- Verfahren. Bei PECVD-Verfahren wird die Abscheidung dadurch bewirkt, dass reaktive Gase zwischen parallelen Elektroden zugeführt werden, einer geerdeten Elektrode und einer RF-Elektrode. Die kapazitive Kopplung zwischen den Elektroden regt die reaktiven Gase zu einem Plasma an, welches wiederum zu der gewünschten chemischen Reaktion führt. Dadurch wird das Reaktionsprodukt, in diesem Fall SiC, auf dem Substrat abgeschieden. Das Substrat, das auf der geerdeten Elektrode angeordnet ist, wird typischerweise auf Temperaturen zwischen 100 °C bis 120 °C erhitzt, um die Integrität von Standard-Fotolacken zu gewährleisten.

Aufgrund seiner speziellen chemischen und physikalischen Eigenschaften geht Siliziumkarbid eine besonders enge Bindung mit der darunterliegenden Polymerschicht, beispielsweise Polyimid, ein.

Auf die Siliziumkarbidschicht 108 wird anschließend eine transparente elektrisch halbleitende TCO-Schicht 110 aufgebracht. Dieser Zustand ist in Fig. 3 illustriert. Gemäß der vorliegenden Erfindung kann das elektrisch leitfähige Oxid beispielsweise Indiumzinnoxid, ITO, Fluor-Zinn-Oxid, FTO, Aluminium-Zink-Oxid, AZO, und/oder Antimon-Zinn-Oxid, ATO, umfassen.

Beispielsweise kann eine solche ITO-Schicht 110 mithilfe von reaktiver Kathodenzerstäubung abgeschieden werden. Wie bereits ausgeführt, bezeichnet die reaktive Kathodenzerstäubung ein Abscheideverfahren, bei dem Atome aus einem Festkörper (Target) durch Beschuss mit energiereichen Ionen (vorwiegend Edelgasionen) herausgelöst werden und in die Gasphase übergehen, wobei in einem inerten Arbeitsgas (z. B. Argon) ein oder mehrere reaktive Gase (z. B. Sauerstoff oder Stickstoff) zugesetzt werden. Die Gase reagieren am Target, in der Vakuumkammer oder am Substrat mit den zerstäubten Schichtatomen und bilden neue Materialien. Die entstandenen Reaktionsprodukte, im vorliegenden Fall ITO, scheiden sich anschließend an der Substratoberfläche ab.

Aufgrund des Siliziumanteils im Siliziumkarbid 108 ist die Siliziumkarbidschicht auch in der Lage, eine feste Bindung zu der ITO-Schicht 110 einzugehen. Somit bildet die Siliziumkarbidschicht 108 einen Haftvermittler zwischen dem transparenten Polymermaterial (Polyimid) 104 und dem elektrisch leitfähigen Material TCO, beispielsweise ITO, 110.

Im nächsten Schritt wird durch den Lift-off des Fotolacks 106 der Haftvermittler 108 wie auch das TCO 110 an all den Stellen entfernt, an denen es nicht gewünscht ist. Wie in Figur 4 gezeigt, bleiben lediglich die über den Haftvermittler 108 mit dem Untergrund 104 verbundenen strukturierten TCO Schichten 110 stehen.

Wie in Figur 5 gezeigt, kann optional eine weitere Polyimidschicht als Deckschicht 112 auf der strukturierten TCO-Schicht 110 abgeschieden werden. Jede andere transparente Polymerschicht ist selbstverständlich auch als Deckschicht 112 geeignet. In dem gezeigten Beispiel bestehen die Trägerschicht 104 und die Deckschicht 112 aus demselben Material. Das muss aber nicht sein, sondern es können selbstverständlich auch unterschiedliche Materialien verwendet werden. Für die Deckschicht 112 wie auch für die Trägerschicht 104 kommen beispielsweise die folgenden Materialien in Betracht: Polyimid, PI, Polyethylenterephthalat, PET, Polyethylen, PE, Polycabonat, PC, Polyvinylchlorid, PVC, Polyamid, PA, Polytetrafluorethylen, PTFE, Polymethylmetacrylat, PMMA, Polyetheretherketon, PEEK, Polysulfon, PSU, Poly(p-xylylene), Polydimethylsiloxan, PDMS, und/oder Polypropylen, PP, auf. Besonders inert und chemisch stabil ist dabei Polyimid.

Diese Deckschicht 112 dient der elektrischen Isolation, aber auch dem Schutz gegenüber chemischen und mechanischen Umwelteinflüssen. Die Deckschicht 112 kann eine Polyimidschicht sein, die in Form einer flüssigen Vorstufe aufgeschleudert und anschließend thermisch behandelt wird, um ausgehärtet zu werden. Hierzu sind, wie dies bekannt ist, vergleichsweise hohe Temperaturen, beispielsweise 450° während 10 Minuten, erforderlich. Es konnte gezeigt werden, dass die Haftung des TCO-Films 110 auf der Trägerschicht 104 durch diese Beanspruchung nicht beeinträchtigt wird. Mithin erlaubt es das Vorsehen des erfindungsgemäßen Siliziumkarbidhaftvermittlers, transparente elektrisch leitfähige Schichten nach dem Aufbringen auf ihren Träger weiteren, auch höhere Temperaturen involvierenden Prozessschritten zu unterziehen. Insbesondere können transparente elektrisch leitfähige Schichten in Polymere eingebettet werden, so dass ein transparenter, flexibler Aufbau erreicht werden kann, der nach außen geschützt und elektrisch isoliert ist.

Um die TCO-Schicht 110 elektrisch von außen kontaktieren zu können, werden durch Öffnungen 114 in der Deckschicht 112 Kontaktflächen und/oder aktive Strukturen beispielsweise mithilfe eines Trockenätzschritts freigelegt. Weiterhin wird die transparente flexible Trägerschicht 104 von dem Siliziumsubstrat 102 getrennt. Dies kann ebenfalls durch einen Ätzschritt erfolgen. Schließlich kann (in den Figuren nicht gezeigt) eine Vereinzelung von Einzelkomponenten vorgesehen sein, die als Batch gemeinsam prozessiert werden, solange sie auf dem Siliziumwafer 102 angeordnet sind.

Figur 6 zeigt die fertiggestellte transparente Mehrlagenstruktur 100 mit den schematisch dargestellten Öffnungen 114.

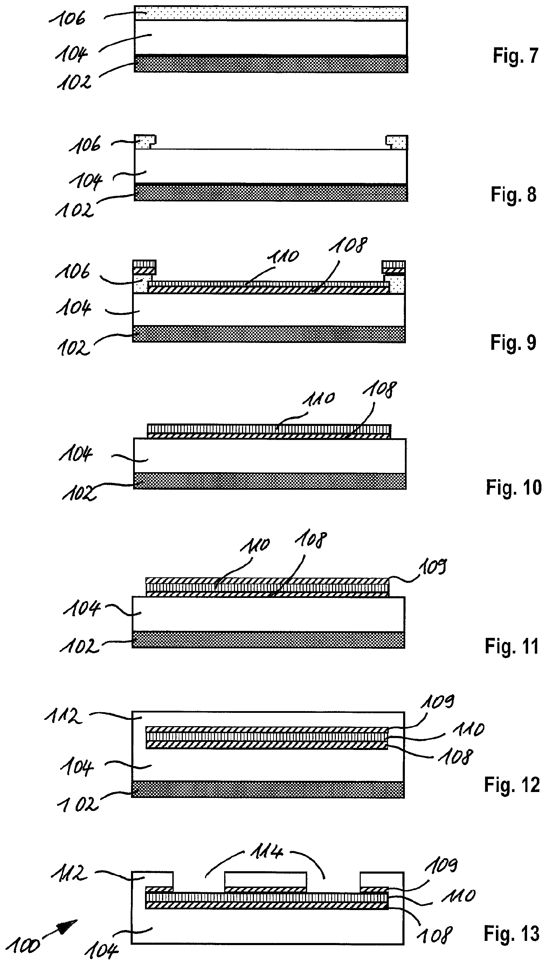

Mit Bezug auf die Figuren 7 bis 13 wird nachfolgend die Herstellung einer transparenten Mehrschichtanordnung gemäß einer weiteren vorteilhaften Ausführungsform beschrieben.

Die in den Figuren 7 bis 10 gezeigten Herstellungsschritte entsprechen denen aus den Figuren 1 bis 4 und die Beschreibung soll daher nicht nochmals wiederholt werden.

Wie in Figur 11 schematisch dargestellt, wird gemäß einer weiteren Ausführungsform eine weitere Haftvermittelschicht 109 zwischen der Deckschicht 112 und der darunterliegenden TCO-Schicht 110 vorgesehen. Die Haftvermittlerschicht 109 kann zum einen durch eine weitere Siliziumkarbidschicht entsprechend der Siliziumkarbidschicht 108 gebildet sein. Es ließ sich aber in experimentellen Untersuchungen zeigen, dass die Haftvermittlung zwischen einem auf dem TCO-Film abgeschiedenen Deckschichtpolymer nicht identisch ist zu der Haftvermittlung zwischen einem auf dem Polymersubstrat abgeschiedenen TCO-Film. Insbesondere kann eine noch weiter verbesserte Haftung der Deckschicht 112 auf dem TCO erreicht werden, indem zusätzlich zu einer weiteren Siliziumkarbidschicht eine Diamond-Like-Carbon (DLC)-Schicht aufgebracht wird, bevor die Polymerdeckschicht abgeschieden wird. Die DLC-Schicht wird beispielsweise in einem Niedertemperaturverfahren, wie einer PECVD-Abscheidung bei maximal 100 °C, aufgebracht. Vorzugsweise hat eine solche zusätzliche DLC-Schicht eine Dicke von ca. 10 nm. Auf diese Weise kann die optimale Adhäsion der Polymerdeckschicht erreicht werden. Damit wird anstelle der in Fig. 5 gezeigten unmittelbaren Abdeckung der TCO-Schicht 110 mit der Deckschicht 112 noch die Doppelschicht SiC-DLC als Haftvermittlerschicht 109 zwischen der TCO-Schicht 110 und der Deckschicht 112 vorgesehen.

Wie in Figur 12 gezeigt, kann analog zu Fig. 5 optional eine weitere Polyimidschicht als Deckschicht 112 auf der strukturierten TCO-Schicht 110 abgeschieden werden. Diese Deckschicht 112 dient der elektrischen Isolation, aber auch dem Schutz gegenüber chemischen und mechanischen Umwelteinflüssen.

Um die TCO-Schicht 110 elektrisch von außen kontaktieren zu können, werden durch Öffnungen 114 in der Deckschicht 112 Kontaktflächen und/oder aktive Strukturen beispielsweise mithilfe eines Trockenätzschritts freigelegt. Dabei wird auch die Haftvermittlerschicht 109 geöffnet. Weiterhin wird die transparente flexible Trägerschicht 104 von dem Siliziumsubstrat 102 getrennt. Dies kann ebenfalls durch einen Ätzschritt erfolgen. Schließlich kann wiederum (in den Figuren nicht gezeigt) eine Vereinzelung von Einzelkomponenten vorgesehen sein, die als Batch gemeinsam prozessiert werden, solange sie auf dem Siliziumwafer 102 angeordnet sind.

Figur 13 zeigt die fertiggestellte transparente Mehrlagenstruktur 100 mit den schematisch dargestellten Öffnungen 114.

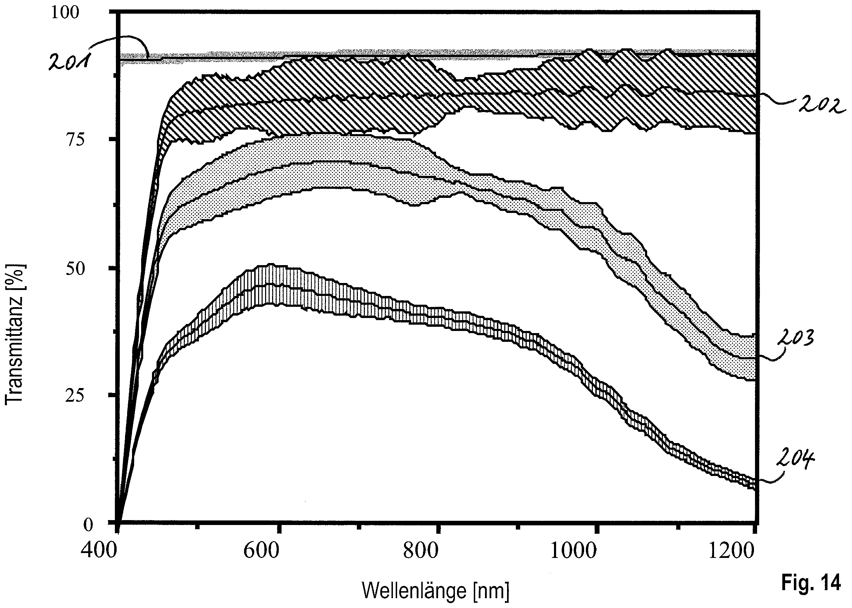

Figur 14 zeigt die Transmittanz (in %) für die verschiedenen in der transparenten Mehrlagenstruktur 100 vorgesehenen Materialien in Abhängigkeit von der Wellenlänge (in nm) im Vergleich zu einer Glasschicht, die für die Messung der Transmittanz als Unterlage erforderlich ist. Jede Kurve zeigt den Mittelwert der Messergebnisse und die zugehörige Standardabweichung. Dabei bezeichnet die Kurve 201 die Durchlässigkeit von Glas, die Kurve 202 die Durchlässigkeit einer 5 µm dicken PI-Schicht auf einer Glasunterlage, die Kurve 203 die Durchlässigkeit einer 300 nm dicken ITO-Schicht auf 5 µm PI und der Glasunterlage, und die Kurve 204 die Durchlässigkeit einer 600 nm dicken ITO-Schicht auf 5 µm PI und der Glasunterlage. Dabei ist jeweils eine SiC-Haftvermittlerschicht zwischen dem PI-Träger und der ITO-Schicht angeordnet.

Wie aus Figur 14 erkennbar, hat die Transmittanz von Glas (Kurve 201) für sichtbares bis nahinfrarotes Licht einen fast konstanten Wert von 91 %, während durch die PI-Schicht etwa 80 % des sichtbaren Lichts über 470 nm dringen (Kurve 202). Der Mehrschichtaufbau mit einer ITO-Schicht zeigt eine maximale Transmittanz im Bereich von 600 nm, wobei die Transmittanz signifikant von der Schichtdicke der ITO-Schicht abhängt (Kurven 203 und 204).

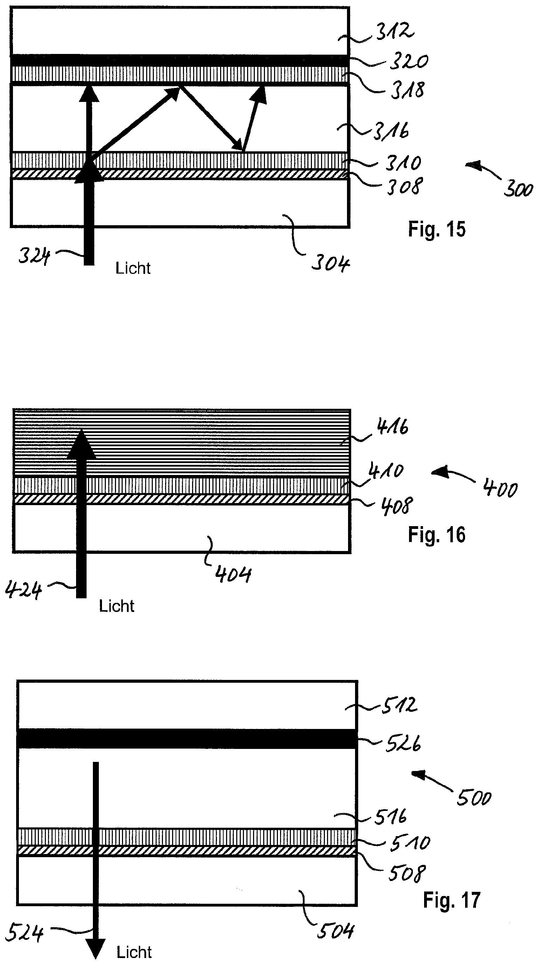

Mit Bezug auf die Figuren 15 bis 17 werden nachfolgend Anwendungsbeispiele für den erfindungsgemäßen transparenten Mehrschichtaufbau gezeigt, bei denen der Herstellungsprozess jeweils analog den Schritten aus Figur 1 bis 6 von unten nach oben abläuft.

Figur 15 zeigt ein erstes technisches Anwendungsbeispiel für die erfindungsgemäße transparente Mehrschichtstruktur. In dieser schematischen Schnittdarstellung ist eine sogenannte mikromorphe Solarzelle 300 mit hydrogenisiertem amorphem und mikrokristallinem Silizium (a-Si:H/µc-Si:H) als aktiver Schicht 316 gezeigt. Wie dies bekannt ist und beispielsweise in dem Artikel H. Liu, V. Avrutin, N. Izyumskaya, Ü. Özgür, and H. Morkoç, "Transparent conducting oxides for electrode applications in light emitting and absorbing devices," Superlattices and Microstructures, vol. 48, no. 5, pp. 458-484, 2010, beschrieben ist, wird bei bekannten Solarzellen an der Seite des Lichteinfalls ein Glassubstrat ("Superstrate") verwendet, welches keine mechanische Flexibilität zulässt. Demgegenüber weist die erfindungsgemäße Solarzelle 300 auf der Seite des Lichteinfalls ein flexibles transparentes Polymerträgermaterial 304 als Superstrate auf. Über eine SiC-Haftvermittlerschicht 308 ist eine TCO-Frontelektrodenschicht 310 mit dem Polymerträgermaterial 304 verbunden. Das SiC 308 ermöglicht somit eine flexible und transparente Vorderseite, die eine Korrosion der TCO-Schicht 310 verhindert.

Als aktive Schicht 316 (die auch als Absorberschicht bezeichnet wird) ist eine a-Si:H/µc-Si:H-Schicht vorgesehen. Auf diese photovoltaisch aktive Schicht 316 folgt eine weitere TCO-Schicht 318, die als Rückseitenkontakt dient. Eine Metallschicht 320 dient der Verspiegelung, als Diffusionsbarriere und der erhöhten elektrischen Leitfähigkeit. Eine weitere Polymerschicht 312 dient als verkapselnde Deckschicht.

Licht 324, das durch die transparente Trägerschicht 304 einfällt, wird aufgrund der unterschiedlichen Brechungsindizes der Silizium- bzw. TCO-Schichten 310, 316, 318 mehrfach reflektiert und gestreut und auf diese Weise in der Siliziumabsorberschicht 316 "gefangen", wie dies in Figur 15 illustriert ist. Auf diese Weise kann die Dicke der Absorberschicht 316 vergleichsweise geringgehalten werden, was Kosten spart und die Stabilität der Solarzelle 300 erhöht.

In vorteilhafter Weise kann die gesamte Solarzelle 300 biegsam sein, so dass sie z. B. im unbenutzten Zustand aufgerollt werden kann oder sich unterschiedlichen Untergrundprofilen anpassen kann.

Als weiteres technisches Anwendungsbeispiel der erfindungsgemäßen transparenten Mehrschichtstruktur ist in Figur 16 eine Solarzelle 400 mit einer CdTe (Cadmiumtellurid)- oder CIGS (Kupfer-Indium-Gallium-Diselenid)-Absorberschicht 416 gezeigt. Generell können alle aktuellen Dünnschichtsolarzellen mit den zugehörigen Schichten erfindungsgemäß auf flexible Substrate überführt werden. Sogar organische Solarzellen mit fotosensitiven Schichten können auf diese Weise stabilisiert werden.

Erfindungsgemäß weist die Solarzelle 400 auf der Seite des Lichteinfalls 424 ein flexibles transparentes Polymerträgermaterial 404 auf. Über eine SiC-Haftvermittlerschicht 408 ist eine TCO-Frontelektrodenschicht 410 mit dem Polymerträgermaterial 404 verbunden. Die SiC-Haftvermittlerschicht 408 ermöglicht somit eine flexible und transparente Vorderseite, die eine Korrosion der TCO-Schicht 410 verhindert. Die aktive Schicht 416 ist durch eine CdTe- oder CIGS-Absorberschicht gebildet. Wie dies bekannt ist und z. B. in dem Artikel H. Liu, V. Avrutin, N. Izyumskaya, Ü. Özgür, and H. Morkoç, "Transparent conducting oxides for electrode applications in light emitting and absorbing devices," Superlattices and Microstructures, vol. 48, no. 5, pp. 458-484, 2010, erläutert wird, ist die Absorberschicht 416 im Fall von CdTe-Solarzellen üblicherweise ein Mehrschichtaufbau, der CdTe- und CdS-Schichten sowie eine Rückseitenmetallisierung umfasst.

Im Fall von CIGS-Solarzellen beinhaltet die Absorberschicht neben dem eigentlichen CIGS-Absorbermaterial außerdem noch eine CdS-Schicht und eine Rückseitenmetallisierung. Es ist allerdings für einen Fachmann klar, dass die erfindungsgemäßen Prinzipien mit jeder benötigten weiteren Schichtfolge kompatibel ist, die gegebenenfalls noch auf die Absorberschicht 416 aufgebracht wird.

Generell können alle aktuellen Dünnschichtsolarzellen mit den zugehörigen Schichten erfindungsgemäß auf flexible Substrate überführt werden. Sogar organische Solarzellen mit fotosensitiven Schichten können auf diese Weise stabilisiert werden.

Als weiteres technisches Anwendungsbeispiel einer transparenten Mehrschichtanordnung gemäß der vorliegenden Erfindung ist in Figur 17 eine organische lichtemittierende Diode (OLED) 500 dargestellt.

Die OLED 500 weist eine aktive organische Schicht 516 zwischen zwei Elektroden, einer Metallkathode 526 und einer transparenten TCO-Anode 510 auf. Die typische Dicke der organischen Filme beträgt etwa 100 bis 200 nm. Dabei werden in der Regel zwei Arten organischer Materialien eingesetzt: langkettige Polymere oder kleine Moleküle. Wird zwischen der Anode und der Kathode eine Spannung angelegt, injiziert die Kathode 526 Elektronen in den Film 516. Gleichzeitig werden Löcher (positive Ladungen) von der transparenten Anode 510 mit hoher Austrittsarbeit in das organische Material 106 injiziert. Im elektrischen Feld wandern positive und negative Ladungen durch den organischen Film 516. Bei ihrer Rekombination bilden sie angeregte Zustände. Zerfallen diese, werden Photonen ausgesendet und Licht 524 tritt aus.

Erfindungsgemäß ist die TCO-Schicht 510 über eine Siliziumkarbidschicht 508 mit einer transparenten Polymerschicht 504 verbunden. Eine Polymerdeckschicht 512 schließt die Schichtfolge der OLED 500 ab. Auf diese Weise kann das Bauelement komplett verkapselt werden, um gegen äußere Einflüsse geschützt zu wein. Darüber hinaus ist die OLED 500 vollständig flexibel, weil auf einen Glasträger verzichtet werden kann.

Zusammenfassend sieht die vorliegende Erfindung Siliziumkarbid als transparenten Haftvermittler zwischen Polymeren und TCOs vor, insbesondere für flexible Dünnfilmanwendungen im Bereich Flüssigkristallbildschirmen, organischen Leuchtdioden, Touchscreens, schaltbaren Verglasungen, Dünnschicht-Solarzellen, Photovoltaik, Displaytechnik, Beleuchtungstechnik, Automobiltechnik, Architekturverglasung, elektrophysiologischen Elektroden, pH-Sensoren und Antikörperdetektoren.

Damit gelingt eine erfolgreiche nicht-hermetische Verkapselung von TCO Schichten, insbesondere für den langzeitstabilen Einsatz in wässerigen Medien (oder feuchten Umgebungen). Dadurch werden thermisch und mechanisch stabile durchsichtige Schichten für die oben genannten Anwendungen bereitgestellt.

**Bezugszeichenliste:**

| **Bezugsziffer** | **Beschreibung** |
|---|---|
| 100 | Mehrschichtanordnung |
| 102 | Silizium |
| 104, 304, 404, 504 | Transparente Trägerstruktur; Polyimid |
| 106 | Fotolack |
| 108, 308, 408, 508 | Siliziumkarbid |
| 109 | Zweite Haftvermittlerschicht |
| 110, 310, 410, 510 | Elektrisch leitfähige transparente Schicht; TCO; ITO |
| 112, 312, 512 | Deckschicht |
| 114 | Öffnungen zum Freilegen der TCO-Schicht |
| 201-204 | Transmittanzkurven |
| 300, 400 | Solarzelle |
| 316, 416, 516 | Aktive Schicht |
| 318 | Zweite TCO-Schicht |
| 320 | Metallschicht |
| 324, 424, 524 | Licht |
| 500 | OLED |
| 526 | Kathode |

## Patentansprüche

1. Transparente Mehrschichtanordnung (100) umfassend:
eine transparente Trägerstruktur (104), die ein Polymermaterial aufweist,
eine elektrisch leitfähige transparente Schicht (110), die ein elektrisch leitfähiges Oxid aufweist,
**dadurch gekennzeichnet, dass**
als Haftvermittler zwischen der Trägerstruktur (104) und der elektrisch leitfähigen transparenten Schicht (110) eine Siliziumkarbidschicht (108) angeordnet ist.

2. Transparente Mehrschichtanordnung nach Anspruch 1, wobei das Polymermaterial der Trägerstruktur (104) Polyimid, PI, Polyethylenterephthalat, PET, Polyethylen, PE, Polycabonat, PC, Polyvinylchlorid, PVC, Polyamid, PA, Polytetrafluorethylen, PTFE, Polymethylmetacrylat, PMMA, Polyetheretherketon, PEEK, Polysulfon, PSU, Poly(p-xylylene), Polydimethylsiloxan, PDMS, und/oder Polypropylen, PP, umfasst.

3. Transparente Mehrschichtanordnung nach Anspruch 1 oder 2, wobei das elektrisch leitfähige Oxid Indiumzinnoxid, ITO, Fluor-Zinn-Oxid, FTO, Aluminium-Zink-Oxid, AZO, und/oder Antimon-Zinn-Oxid, ATO, umfasst.

4. Transparente Mehrschichtanordnung nach einem der vorhergehenden Ansprüche, wobei die Siliziumkarbidschicht (108) eine Dicke zwischen 10 nm und 100 nm, vorzugsweise etwa 50 nm, hat.

5. Transparente Mehrschichtanordnung nach einem der vorhergehenden Ansprüche, wobei die elektrisch leitfähige transparente Schicht (110) strukturiert ist, um mindestens eine Elektrode auszubilden.

6. Transparente Mehrschichtanordnung nach einem der vorhergehenden Ansprüche, wobei weiterhin eine transparente Deckschicht (112), die ein Polymermaterial aufweist und die elektrisch leitfähige transparente Schicht (110) wenigstens teilweise abdeckt, vorgesehen ist.

7. Transparente Mehrschichtanordnung nach Anspruch 6, wobei zwischen der Deckschicht (112) und der elektrisch leitfähigen transparenten Schicht (110) als Haftvermittler eine zweite Siliziumkarbidschicht und/oder eine Doppelschicht aus einer Siliziumkarbidschicht und einer Diamond-Like-Carbon (DLC)-Schicht (109) angeordnet ist.

8. Verfahren zum Herstellen einer transparenten Mehrschichtanordnung (100), wobei das Verfahren die folgenden Schritte umfasst:
Bereitstellen einer transparenten Trägerstruktur (104), die ein Polymermaterial aufweist,
Aufbringen einer Siliziumkarbidschicht (108) auf die Trägerstruktur (104),
Aufbringen einer elektrisch leitfähigen transparenten Schicht (110), die ein elektrisch leitfähiges Oxid aufweist, auf die Siliziumkarbidschicht (108), so dass die Siliziumkarbidschicht (108) einen Haftvermittler zwischen der Trägerstruktur (104) und der elektrisch leitfähigen transparenten Schicht (110) ausbildet.

9. Verfahren nach Anspruch 8, wobei die elektrisch leitfähige transparente Schicht (110) mittels eines Fotolithografieprozesses strukturiert wird.

10. Verfahren nach Anspruch 8 oder 9, wobei die Siliziumkarbidschicht (108) in einem PECVD Verfahren auf der Trägerstruktur abgeschieden wird und/oder wobei die elektrisch leitfähige transparente Schicht (110) mittels reaktiver Kathodenzerstäubung auf der Siliziumkarbidschicht (108) abgeschieden wird.

11. Verfahren nach einem der Schritte 8 bis 10, wobei weiterhin eine transparente Deckschicht (112), die ein Polymermaterial aufweist und die elektrisch leitfähige transparente Schicht (110) wenigstens teilweise abdeckt, aufgebracht wird.

12. Verfahren nach Anspruch 11, wobei zwischen der Deckschicht (112) und der elektrisch leitfähigen transparenten Schicht (110) als Haftvermittler eine zweite Siliziumkarbidschicht und DLC-Schicht (109) abgeschieden wird.

13. Verfahren nach Anspruch 11 oder 12, wobei in einem Ätzschritt Kontaktöffnungen (114) in die Deckschicht (112) eingebracht werden, durch die hindurch die elektrisch leitfähige transparente Schicht kontaktierbar (110) ist.

14. Solarzelle (300, 400) mit einer Absorberschicht (316, 416) und einer transparenten Mehrschichtanordnung nach einem der Ansprüche 1 bis 7, wobei die elektrisch leitfähige transparente Schicht elektrisch und optisch mit der Absorberschicht verbunden ist.

15. Organische Leuchtdiode, OLED, (500) mit einer Kathode (526), einer Emitterschicht (516) und einer Anode (508), wobei die OLED eine transparente Mehrschichtanordnung nach einem der Ansprüche 1 bis 7 aufweist, und wobei die elektrisch leitfähige transparente Schicht die Anode (508) der OLED (500) bildet.

## Claims

1. Transparent multi-layer assembly (100) comprising:
a transparent carrier structure (104) comprising polymer material,
an electrically conductive transparent layer (110) comprising an electrically conductive oxide,
**characterized in that**
a silicon carbide layer (108) is arranged as an adhesion promoter between said carrier structure (104) and said electrically conductive transparent layer (110).

2. Transparent multi-layer assembly according to claim 1, wherein said polymer material of said carrier structure (104) comprises polyimide, PI, polyethylene terephthalate, PET, polyethylene, PE, polycarbonate, PC, polyvinyl chloride, PVC, polyamide, PA, polytetrafluoroethylene, PTFE, polymethyl methacrylate, PMMA, polyether ether ketone, PEEK, polysulfone, PSU, poly (p-xylylene), polydimethylsiloxane, PDMS, and/or polypropylene, PP.

3. Transparent multi-layer assembly according to claim 1 or 2, wherein said electrically conductive oxide comprises indium tin oxide, ITO, fluorine tin oxide, FTO, aluminum zinc oxide, AZO, and/or antimony tin oxide, ATO.

4. Transparent multi-layer assembly according to one of the preceding claims, wherein said silicon carbide layer (108) has a thickness between 10 nm and 100 nm, preferably approximately 50 nm.

5. Transparent multi-layer assembly according to one of the preceding claims, wherein said electrically conductive transparent layer (110) is structured in order to form at least one electrode.

6. Transparent multi-layer assembly according to one of the preceding claims, wherein a transparent top layer (112) comprising polymer material and covering said electrically conductive transparent layer (110) at least in part is furthermore provided.

7. Transparent multi-layer assembly according to claim 6, wherein a second silicon carbide layer and/or a double layer made of a silicon carbide layer and a diamond-like carbon (DLC) layer (109) is arranged between said top layer (112) and said electrically conductive transparent layer (110) as an adhesion promoter.

8. Method for producing a transparent multi-layer assembly (100), said method comprising the following steps:
providing a transparent carrier structure (104) comprising polymer material,
applying a silicon carbide layer (108) onto said carrier structure (104),
applying an electrically conductive transparent layer (110) comprising an electrically conductive oxide onto said silicon carbide layer (108) so that said silicon carbide layer (108) forms an adhesion promoter between said carrier structure (104) and said electrically conductive transparent layer (110).

9. Method according to claim 8, wherein said electrically conductive transparent layer (110) is structured by way of a photolithography process.

10. Method according to claim 8 or 9, wherein said silicon carbide layer (108) is deposited onto said carrier structure in a PECVD process and/or wherein said electrically conductive transparent layer (110) is deposited onto said silicon carbide layer (108) by way of reactive cathode sputtering.

11. Method according to one of the steps 8 to 10, wherein a transparent top layer (112) comprising polymer material and covering said electrically conductive transparent layer (110) at least in part is furthermore applied.

12. Method according to claim 11, wherein a second silicon carbide layer and DLC layer (109) is deposited as an adhesion promoter between said top layer (112) and said electrically conductive transparent layer (110).

13. Method according to claim 11 or 12, wherein contact openings (114) are introduced in an etching step into said top layer (112) through which said electrically conductive transparent layer can be contacted (110).

14. Solar cell (300, 400) with an absorber layer (316, 416) and a transparent multi-layer assembly according to one of the claims 1 to 7, wherein said electrically conductive transparent layer is electrically and optically bonded to said absorber layer.

15. Organic light-emitting diode, OLED, (500) with a cathode (526), an emitter layer (516) and an anode (508), wherein said OLED comprises a transparent multi-layer assembly according to one of the claims 1 to 7, and wherein said electrically conductive transparent layer forms said anode (508) of said OLED (500).

## Revendications

1. Agencement multicouche transparent (100) comprenant :
une structure porteuse transparente (104) comprenant un matériau polymère,
une couche transparente électroconductrice (110) comprenant un oxyde électroconducteur,
**caractérisé en ce qu'**une couche de carbure de silicium (108) est agencée en tant qu'agent adhésif entre la structure porteuse (104) et la couche transparente électroconductrice (110).

2. Agencement multicouche transparent selon la revendication 1, dans lequel le matériau polymère de la structure porteuse (104) comprend du polyimide, PI, du polyéthylène téréphtalate, PET, du polyéthylène, PE, du polycabonate, PC, du polychlorure de vinyle, PVC, du polyamide, PA, du polytétrafluoroéthylène, PTFE, du polyméthacrylate de méthyle, PMMA, de la polyétheréthercétone, PEEK, de la polysulfone, PSU, du poly(p-xylylène), du polydiméthylsiloxane, PDMS, et/ou du polypropylène, PP.

3. Agencement multicouche transparent selon la revendication 1 ou 2, dans lequel l'oxyde électroconducteur comprend l'oxyde d'indium et d'étain, ITO, de l'oxyde d'étain fluoré, FTO, de l'oxyde d'aluminium et de zinc, AZO, et/ou de l'oxyde d'antimoine et d'étain, ATO.

4. Agencement multicouche transparent selon l'une quelconque des revendications précédentes, dans lequel la couche de carbure de silicium (108) présente une épaisseur comprise entre 10 nm et 100 nm, de préférence d'environ 50 nm.

5. Agencement multicouche transparent selon l'une quelconque des revendications précédentes, dans lequel la couche transparente électroconductrice (110) est structurée pour former au moins une électrode.

6. Agencement multicouche transparent selon l'une quelconque des revendications précédentes, dans lequel est en outre prévue une couche de recouvrement transparente (112) qui comprend un matériau polymère et qui recouvre au moins partiellement la couche transparente électroconductrice (110).

7. Agencement multicouche transparent selon la revendication 6, dans lequel une seconde couche de carbure de silicium et/ou une double couche constituée d'une couche de carbure de silicium et d'une couche de carbone de type diamant (DLC) sont agencées entre la couche de recouvrement (112) et la couche transparente électroconductrice (110) en tant qu'agent adhésif.

8. Procédé de fabrication d'un agencement multicouche transparent (100), dans lequel le procédé comprend les étapes suivantes consistant à :
fournir une structure porteuse transparente (104) comprenant un matériau polymère, appliquer une couche de carbure de silicium (108) sur la structure porteuse (104), appliquer une couche transparente électroconductrice (110) comprenant un oxyde électroconducteur sur la couche de carbure de silicium (108) de sorte que la couche de carbure de silicium (108) forme un agent adhésif entre la structure porteuse (104) et la couche transparente électroconductrice (110).

9. Procédé selon la revendication 8, dans lequel la couche transparente électroconductrice (110) est structurée au moyen d'un procédé de photolithographie.

10. Procédé selon la revendication 8 ou 9, dans lequel la couche de carbure de silicium (108) est déposée sur la structure porteuse par un procédé PECVD et/ou dans lequel la couche transparente électroconductrice (110) est déposée sur la couche de carbure de silicium (108) par pulvérisation cathodique réactive.

11. Procédé selon l'une quelconque des revendications 8 à 10, comprenant en outre l'application d'une couche de recouvrement transparente (112) comprenant un matériau polymère et recouvrant au moins partiellement la couche transparente électroconductrice (110).

12. Procédé selon la revendication 11, dans lequel une seconde couche de carbure de silicium et une couche de DLC (109) sont déposées entre la couche de recouvrement (112) et la couche transparente électroconductrice (110) en tant qu'agent adhésif.

13. Procédé selon la revendication 11 ou 12, dans lequel, dans une étape de gravure, des ouvertures de contact (114) sont introduites dans la couche de recouvrement (112) à travers lesquelles la couche transparente électroconductrice peut être mise en contact (110).

14. Cellule solaire (300, 400) comprenant une couche absorbante (316, 416) et un agencement multicouche transparent selon l'une quelconque des revendications 1 à 7, dans laquelle la couche transparente électroconductrice est connectée électriquement et optiquement à la couche absorbante.

15. Diode électroluminescente organique, OLED, (500) comprenant une cathode (526), une couche d'émetteur (516) et une anode (508), dans laquelle la OLED comprend un agencement multicouche transparent selon l'une quelconque des revendications 1 à 7, et dans laquelle la couche transparente électroconductrice forme l'anode (508) de la OLED (500).
